# EUROPEAN PATENT APPLICATION

(11) **EP 1 918 997 A2**
(43) Date of publication of application: **07.05.2008**
(21) Application number: 07020751.9
(22) Date of filing: 24.10.2007
(51) Int. Cl.: H01L 27/32

(54) **Display device and method of manufacturing the same**

(30) Priority: 03.11.2006 KR 20060108550
(71) Applicant: Samsung Electronics Co., Ltd., Suwon-si, Gyeonggi-do 442-742 (KR)
(72) Inventor: Choi, Beohm-Rock, Seoul (KR); Park, Kyong-Tae, Uijeongbu-si Gyeonggi-do (KR); Jung, Kwang-Chul, Seongnam-si Gyeonggi-do (KR); Song, Young-Rok, Yongin-si Geonggi-do (KR)
(74) Representative: Weitzel, Wolfgang

(57) **Abstract**

A display device is provided. The display device includes: a substrate including a display area and a peripheral area; a driving voltage line that is formed in the display area; a first driver that is attached to the peripheral area; and a driving voltage transferring unit that transfers a driving voltage from the first driver to the driving voltage line and that includes a first wiring and a second wiring that are formed in different layers. The first wiring and the second wiring are connected to each other through a plurality of first contact holes for exposing the first wiring and a plurality of second contact holes for exposing the second wiring, in a contact area, and a boundary line of the first wiring and the second wiring is bent in the contact area.

## Description

### BACKGROUND OF THE INVENTION

### (a) Field of the Invention

The present invention relates to a display device, and more particularly, to an organic light emitting display device.

### (b) Description of the Related Art

Organic light emitting devices are currently desirable as a flat panel display device, along with a liquid crystal display (LCD). An active matrix organic light emitting device includes an organic light emitting diode (OLED) and a driving thin film transistor (TFT) for supplying a current to the organic light emitting diode.

The types of TFTs useful in displays include a polysilicon TFT and an amorphous silicon TFT according to the kind of active layer. An organic light emitting device employing a polysilicon TFT is widely used due to various merits, but a manufacturing process of the TFT is complicated and has low uniformity. However, an organic light emitting device employing an amorphous silicon TFT can easily be used to form a wide screen and display has relatively fewer manufacturing processes than the organic light emitting device employing the polysilicon TFT.

As the size of an organic light emitting device increases, a consumption of current that is required for providing the same brightness increases. However, because a voltage drop is generated in a process of transferring a high driving voltage due to the increased consumption current, uniformity of a screen display deteriorates and crosstalk is generated.

Accordingly in is desirable to provide a display device having the advantages of improved uniformity of screen display by more stably providing a driving voltage to an organic light emitting device through preventing a voltage drop being generated at a process of transferring the driving voltage.

### SUMMARY OF THE INVENTION

An exemplary embodiment of the present invention provides a display device including: a substrate including a display area and a peripheral area; a driving voltage line that is formed in the display area; a first driver that is attached to the peripheral area; and a driving voltage transferring unit that transfers a driving voltage from the first driver to the driving voltage line and that includes a first wiring and a second wiring that are formed in different layers. The first wiring and the second wiring are connected to each other through a plurality of first contact holes for exposing the first wiring and a plurality of second contact holes for exposing the second wiring, in a contact area, and a boundary line of the first wiring and the second wiring is bent in the contact area.

The display device may further include a connecting member for connecting the first wiring and the second wiring through the plurality of first contact holes and the plurality of second contact holes.

The first wiring may be disposed lower than the second wiring.

The boundary line may have a plurality of convex portions and a plurality of recess portions that are disposed at a vertical side and that are extended in one direction about the vertical side.

The boundary line may have a plurality of pairs of convex portions and a plurality of pairs of recess portions, each pair being in opposite directions around a center vertical line.

The boundary line may have a closed bent line.

The boundary line may have a pair of recess portions that are opposite to each other about the closed bent line.

The display device may further include a plurality of scanning signal lines that are formed in the display area and a plurality of data lines intersecting the scanning signal lines.

The first wiring may be made of the same material as that of the scanning signal lines or the data lines.

The second wiring may be made of the same material as that of the scanning signal lines or the data lines.

The connecting member may be made of a transparent conductive material.

The driving voltage transferring unit may be formed along the peripheral area.

The contact area may be opposite to the first driver about the display area.

The display device may further include a second driver for applying a scanning signal to the scanning signal lines.

The second driver may be integrated with the substrate.

The second driver may be divided into two portions that are opposite to each other with the display area disposed therebetween.

The first driver may apply a data voltage to the data line.

The display device may further include an insulating layer that is formed between the first wiring and the second wiring.

Another embodiment of the present invention provides a display device including: a substrate including a display area and a peripheral area; a driving voltage line that is formed in the display area; a first driver that is attached to the peripheral area; and a driving voltage transferring unit that transfers a driving voltage from the first driver to the driving voltage line and that includes a first wiring and a second wiring that are formed in different layers. The first wiring and the second wiring are connected to each other through a plurality of first contact holes for exposing the first wiring and a plurality of second contact holes for exposing the second wiring, in a contact area, and a boundary line of the first wiring and the second wiring is bent in the contact area.

Yet another embodiment of the present invention provides a method of manufacturing a display device including a plurality of pixels, the method including: forming a first wiring on a substrate; forming an insulating layer on the first wiring; forming a second wiring on the insulating layer; forming a passivation layer on the second wiring; forming a first contact hole for exposing the second wiring on the passivation layer; forming a second contact hole for exposing the first wiring on the passivation layer and the insulating layer; and forming a connecting member for connecting the first and second wirings through the first and second contacts holes, wherein the first and second wirings transfer a driving voltage to the pixels and a boundary line of the first and second wirings is bent.

The forming of the second contact hole may include etching the passivation layer, and etching the insulating layer.

The etching of the passivation layer and the etching of the insulating layer may be simultaneously performed.

The boundary line may have a plurality of convex portions and a plurality of recess portions that are disposed at a vertical side and that are extended in one direction about the vertical side.

The boundary line may have a plurality of pairs of convex portions and a plurality of pairs of recess portions, each pair being in opposite directions around a center vertical line.

The boundary line may have a closed bent line.

The boundary line may have a pair of recess portions that are opposite to each other about the closed bent line.

The first and second wirings may be formed along an edge of the substrate.

### BRIEF DESCRIPTION OF THE DRAWINGS

FIG. 1 is a block diagram of an organic light emitting device according to an exemplary embodiment of the present invention.
FIG. 2 is an equivalent circuit diagram of an organic light emitting device according to an exemplary embodiment of the present invention.
FIG. 3 is a cross-sectional view illustrating an example of sections of an organic light emitting diode and a driving transistor of one pixel of the organic light emitting device shown in FIG. 2.
FIG. 4 is a schematic diagram of an organic light emitting diode of the organic light emitting device according to an exemplary embodiment of the present invention.
FIG. 5 is a top plan view schematically illustrating an organic light emitting device according to an exemplary embodiment of the present invention.
FIG. 6 is an enlarged plan view of the area displayed by a dashed line of the organic light emitting device of FIG. 5.
FIG. 7 is a cross-sectional view taken along line VII-VII of FIG. 6.
FIGS. 8 and 9 are views illustrating other examples of the organic light emitting device of FIG. 6.

### DETAILED DESCRIPTION OF THE EMBODIMENTS

The present invention is described more fully hereinafter with reference to the accompanying drawings, in which exemplary embodiments of the invention are shown. As those skilled in the art would realize, the described embodiments may be modified in various different ways, all without departing from the spirit or scope of the present invention.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

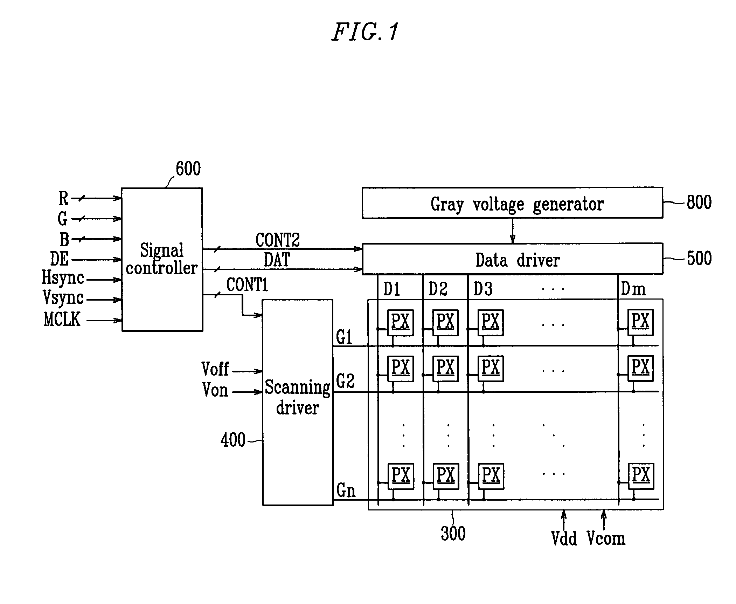

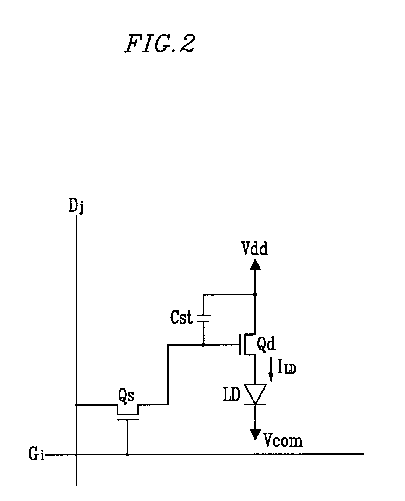

FIG. 1 is a block diagram of an organic light emitting device according to an exemplary embodiment of the present invention, and FIG. 2 is an equivalent circuit diagram of an organic light emitting device according to an exemplary embodiment of the present invention.

As shown in FIG. 1, the organic light emitting device according to an exemplary embodiment of the present invention includes a display panel 300, a scanning driver 400 and data driver 500 that are connected to the display panel 300, a gray voltage generator 800 that is connected to the data driver 500, and a signal controller 600 that controls them.

The display panel 300 includes a plurality of signal lines G₁-Gₙ and D₁-Dₘ, a plurality of driving voltage lines (not shown) for providing driving voltage Vdd, and a plurality of pixels PX that are connected thereto and that are arranged in approximately a matrix form from the view of an equivalent circuit.

The signal lines G₁-Gₙ and D₁-Dₘ include a plurality of scanning lines G₁-Gₙ, also sometimes referred to as gate lines, that transfer a scanning signal, data lines D₁-Dₘ that transfer a data voltage, and a plurality of driving voltage lines (not shown) that transfer a driving voltage Vdd. The scanning lines G₁-Gₙ extend in approximately a row direction and are generally parallel to each other, and the data lines D₁-Dₘ and the driving voltage lines extend in approximately a column direction and are generally parallel to each other.

The driving voltage lines extend approximately parallel to the data line Dj, and the driving voltage Vdd is applied to an upward end or a downward end of the display panel 300. However, the driving voltage line may be extended parallel to the scanning signal line Gi.

As shown in FIG. 2 each pixel PX of the organic light emitting device according to an exemplary embodiment of the present invention includes an organic light emitting element LD, a driving transistor Qd, a storage capacitor Cst, and a switching transistor Qs.

The switching transistor Qs has a control terminal, an input terminal, and an output terminal, and the control terminal is connected to the scanning line Gi, the input terminal is connected to the data line Dj, and the output terminal is connected to the driving transistor Qd. The switching transistor Qs transfers a data signal that is applied to the data line Dj in response to a scanning signal that is applied to the scanning line Gi.

The driving transistor Qd also has a control terminal, an input terminal, and an output terminal, and the control terminal is connected to the switching transistor Qs, the input terminal is connected to the driving voltage line to receive a driving voltage Vdd, and the output terminal is connected to the organic light emitting element LD. The driving transistor Qd allows an output current I_{LD} to flow, which has a magnitude changing according to a voltage that is applied between the control terminal and the output terminal.

The storage capacitor Cst is connected between the control terminal and the input terminal of the driving transistor Qd. The storage capacitor Cst charges a data signal that is applied to the control terminal of the driving transistor Qd and sustains the data signal even after the switching transistor Qs is turned off.

The organic light emitting element LD, which is an organic light emitting diode OLED, has an anode that is connected to an output terminal of the driving transistor Qd and a cathode that is connected to a common voltage Vcom. The organic light emitting element LD displays an image by emitting light with different intensity according to an output current I_{LD} of the driving transistor Qd.

The switching transistor Qs and the driving transistor Qd are n-channel field effect transistors (FETs) that are made of amorphous silicon or polysilicon. Alternatively, at least one of the switching transistor Qs and the driving transistor Qd may be a p-channel FET. Further, a connection between the transistors Qs and Qd, the capacitor Cst, and the organic light emitting element LD can be changed.

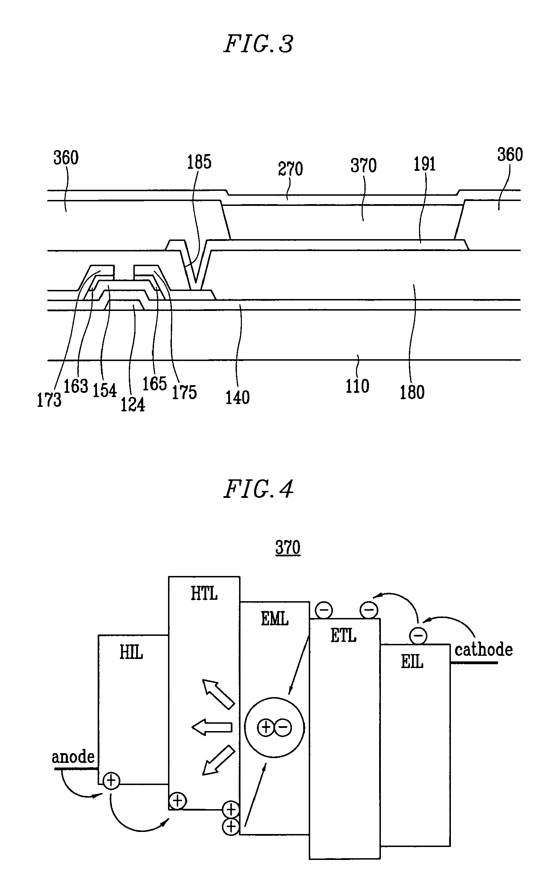

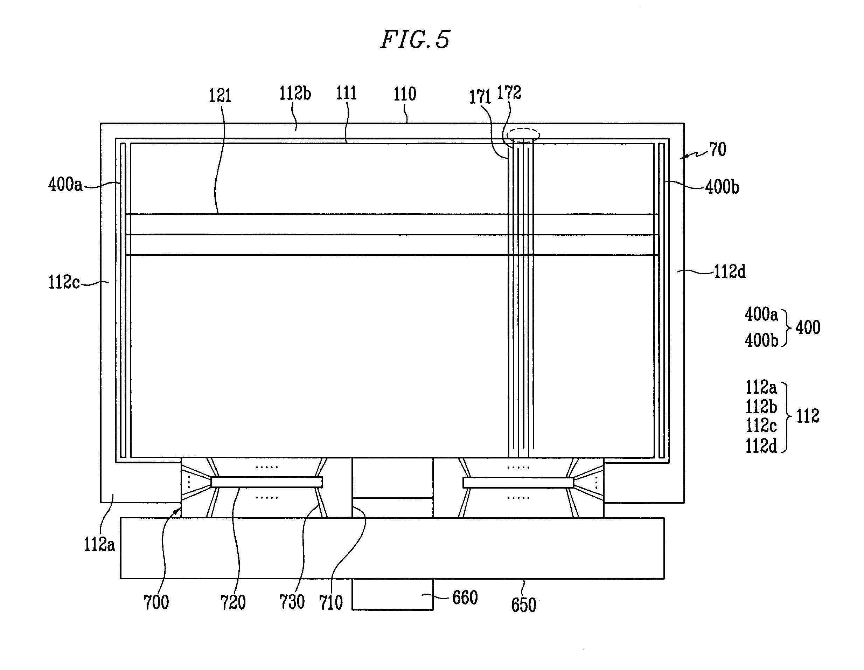

The structure of the organic light emitting diode LD and the driving transistor Qd of the organic light emitting device shown in FIG. 2 is described below in detail with reference to FIGS. 3 and 4

FIG. 3 is a cross-sectional view illustrating one example of sections of an organic light emitting diode and a driving transistor of one pixel of the organic light emitting device shown in FIG. 2, and FIG. 4 is a schematic diagram of an organic light emitting diode of the organic light emitting device according to an exemplary embodiment of the present invention.

A control terminal electrode 124 is formed on an insulation substrate 110. It is preferable that the control terminal electrode 124 is made of an aluminum metal such as aluminum (Al) or an aluminum alloy, a silver metal such as silver (Ag) or a silver alloy, a copper metal such as copper (Cu) or a copper alloy, a molybdenum metal such as molybdenum (Mo) or a molybdenum alloy, chromium (Cr), titanium (Ti), or thallium (Ta). However, the control terminal electrode 124 may have a multi-layer structure including two conductive layers (not shown) that have different physical properties. One of the two conductive layers may be made of a metal, for example, an aluminum metal, a silver metal, or a copper metal, having low resistivity to reduce a signal delay or a voltage drop. The other conductive layer may be made of a material, for example, a molybdenum metal, chromium, titanium, or thallium, having excellent physical, chemical, and electrical contact characteristics with other materials, particularly, indium tin oxide (ITO) and indium zinc oxide (IZO). A good example of such a combination may include a chromium lower layer and an aluminum (alloy) upper layer, or an aluminum (alloy) lower layer and a molybdenum (alloy) upper layer. However, the control terminal electrode 124 may be made of various other metals or conductors. The lateral sides of the control terminal electrode 124 are inclined to a surface of the substrate 110, at an inclination angle thereof ranges from 30° to 80°.

An insulating layer 140 that is made of silicon nitride (SiNx), etc., is formed on the control terminal electrode 124.

A semiconductor layer 154 that is made, for example, of hydrogenated amorphous silicon (a-Si is an abbreviation for amorphous silicon), or polysilicon, is formed on the insulating layer 140.

A pair of ohmic contacts 163 and 165, which are made of a material such as n+ hydrogenated amorphous silicon in which an n-type impurity is doped with high concentration or silicide, are formed on the semiconductor 154.

The lateral sides of the semiconductor layer 154 and the ohmic contacts 163 and 165 are inclined to a surface of the substrate 110, and an inclination angle thereof ranges from 30° to 80°.

An input terminal electrode 173 and output terminal electrode 175 are formed on the ohmic contacts 163 and 165 and the insulating layer 140. It is preferable that the input terminal electrode 173 and the output terminal electrode 175 are made of a refractory metal such as tantalum, titanium, chromium, and a molybdenum metal. The input terminal electrode 173 and the output terminal electrode 175 can have a multi-layer structure including a lower layer (not shown) that is made of a refractory metal and an upper layer (not shown) that is made of a low resistance material and that is positioned thereon. An example of a multi-layer structure includes a double layer of a chromium or molybdenum (alloy) lower layer and an aluminum upper layer, and a triple layer of a molybdenum (alloy) lower layer, an aluminum (alloy) middle layer, and a -molybdenum (alloy) upper layer. The lateral sides of the input terminal electrode 173 and the output terminal electrode 175 may also be inclined at about 30°-80°, like the control terminal electrode 124.

The input terminal electrode 173 and the output terminal electrode 175 are separated from each other and are positioned at each side of the control terminal electrode 124. The control terminal electrode 124, the input terminal electrode 173, and the output terminal electrode 175 constitute a driving transistor Qd, along with the semiconductor layer 154, and a channel thereof is formed in the semiconductor layer 154 between the input terminal electrode 173 and the output terminal electrode 175.

The ohmic contacts 163 and 165 respectively exist only between the lower semiconductor layer 154 and the upper input terminal electrode 173 and output terminal electrode 175 and perform a function of lowering contact resistance therebetween. The semiconductor layer 154 has a portion that is exposed without being covered with the input terminal electrode 173 and the output terminal electrode 175.

A passivation layer 180 is formed on the input terminal electrode 173, the output terminal electrode 175, the exposed portion of the semiconductor 154, and the insulation layer 140. The passivation layer 180 is made of an inorganic insulator such as silicon nitride SiNx and silicon oxide SiO₂, an organic insulator, or a low dielectric constant insulator. It is preferable that a dielectric constant of the low electric constant insulator is 4.0 or less, and the low electric constant insulator includes, for example, a-Si:C:O or a-Si:O:F that are formed with plasma enhanced chemical vapor deposition (PECVD). The passivation layer 180 may be made of an organic insulator having photosensitivity among organic insulators and a surface thereof may be flat. Further, the passivation layer 180 may have a double-layer structure of a lower inorganic layer and an upper organic layer to have the merit of the organic layer while protecting the exposed portion of the semiconductor 154. The contact hole 185 is formed to expose the output terminal electrode 175 on the passivation layer 180.

A pixel electrode 191 is formed on the passivation layer 180. The pixel electrode 191 is physically and electrically connected to the output terminal electrode 175 through the contact hole 185 and is made of a transparent conductive material such as ITO or IZO or a metal having excellent reflectivity such as aluminum or a silver alloy.

A partition 360 is also formed on the passivation layer 180. The partition 360 surrounds a peripheral area of the pixel electrode 191 like a bank and defines openings, and the partition 360 is made of an organic insulating material or an inorganic insulating material.

The organic light emitting member 370 is formed on the pixel electrode 191, and the organic light emitting member 370 is formed within an opening that is surrounded with the partition 360.

As shown in FIG. 4, the organic light emitting member 370 has a multi-layer structure including accessory layers for improving light emitting efficiency of an emitting layer EML in addition to the emitting layer EML. The accessory layer includes an electron transport layer ETL and a hole transport layer HTL for adjusting the balance of electrons and holes, and an electron injecting layer EIL and a hole injecting layer HIL for solidifying the injection of electrons and holes. The accessory layers may be omitted.

The common electrode 270 is formed on the partition 360 and the organic light emitting member 370 to apply a common voltage Vcom. The common electrode 270 is made of a transparent conductive material such as ITO or IZO or a reflective metal including calcium (Ca), barium (Ba), aluminum (Al), and silver (Ag).

The opaque pixel electrode 191 and the transparent common electrode 270 are applied to a top emission organic light emitting device for displaying an image in an upper direction of the display panel 300, and the transparent pixel electrode 191 and the opaque common electrode 270 are applied to a bottom emission organic light emitting device for displaying an image in a lower direction of the display panel 300.

The pixel electrode 191, the organic light emitting member 370, and the common electrode 270 constitute the organic light emitting diode LD shown in FIG. 2, and the pixel electrode 191 becomes an anode and the common electrode 270 becomes a cathode or the pixel electrode 191 becomes a cathode and the common electrode 191 becomes an anode. The organic light emitting diode LD emits light of one of a primary color according to a material of the organic light emitting member 370. The primary colors include, for example, three primary colors of red, green, and blue, and a desired color is displayed with a spatial combination of the three primary colors.

Referring again to FIG. 1, the gray voltage generator 800 generates a plurality of reference gray voltages that are related to luminance of the pixel PX. The number of reference gray voltages is smaller than that of the entire gray.

The scanning driver 400 is connected to the scanning signal lines (G₁-Gₙ) to apply a scanning signal consisting of a combination of a high voltage Von for turning on the switching transistor Qs and a low voltage Voff for turning off the switching transistor Qs to the scanning signal lines (G₁-Gₙ).

The data driver 500 is connected to the data lines (D₁-Dₘ), generates a data voltage by dividing a reference gray voltage that is received from the gray voltage generator 800, and applies the generated data voltage to the data lines (D₁-Dₘ).

The signal controller 600 controls the operation of the scanning driver 400, the data driver 500, and the gray voltage generator 800.

Each of the driving devices 400, 500, 600, and 800 may be integrated on the substrate 110, along with the signal lines (G₁-Gₙ, D₁-Dₘ) and the switching element Q of the TFT. Alternatively, the driving devices 400, 500, 600, and 800 may be directly mounted on the substrate 110 in at least one IC chip form, attached to the substrate 110 in the form of a tape carrier package (TCP) by being mounted on a flexible printed circuit film (not shown), or mounted on a separate printed circuit board (PCB) (not shown). Further, the driving devices 400, 500, 600, and 800 can be integrated in a single chip and in this case, at least one of them or at least one circuit element constituting them may be disposed at the outside of a single chip.

The operation of the organic light emitting device is described below in detail.

The signal controller 600 receives input image signals R, G, and B and an input control signal for controlling the display of the input image signals R, G, and B from an external graphic controller (not shown). The input image signals R, G, and B include luminance information of each pixel PX, and luminance has grays of a given number, for example, 1024 (= 2¹⁰), 256 (= 2⁸), or 64 (= 2⁶). The input control signal includes, for example, a vertical synchronization signal Vsync, a horizontal synchronizing signal Hsync, a main clock MCLK, and a data enable signal DE.

The signal controller 600 generates an output image signal DAT by properly processing the input image signals R, G, and B based on the input control signal according to an operating condition of the display panel 300, and generates a scan control signal CONT1, a data control signal CONT2, etc. The signal controller 600 sends the scan control signal CONT1 to the scanning driver 400, and sends the data control signal CONT2 and the output image signal DAT to the data driver 500.

The scanning control signal CONT1 includes a scanning start signal STV for instructing the scanning start of a high voltage Von and at least one clock signal for controlling an output period of a high voltage Von. The scanning control signal CONT1 may further include an output enable signal OE for limiting a sustain time of a gate-on voltage Von.

The data control signal CONT2 includes a horizontal synchronization start signal STH for informing the transfer start of a digital image signal DAT for one row of pixels PX_{S} and a load signal LOAD and data clock signal HCLK for applying an analog data voltage to the data lines (D₁-Dₘ).

The gray voltage generator 800 generates a reference gray voltage and provides the reference gray voltage to the data driver 500.

The data driver 500 generates a gray voltage for all grays by dividing the reference gray voltage. As the data driver 500 receives output image data DAT for one row of pixels PX_{S} according to a data control signal CONT2 from the signal controller 600 and selects a gray voltage corresponding to the output image data DAT, the data driver 500 converts the digital image signal DAT to an analog data voltage and then applies the analog data voltage to the corresponding data lines (D₁-Dₘ).

The scanning driver 400 converts a scanning signal that is applied to the scanning signal lines (G₁-Gₙ) to a high voltage Von according to the scannning control signal CONT1 from the signal controller 600. The switching transistor Qs which is connected to the scanning signal lines (G₁-Gₙ) is turned on to apply a data voltage that is applied to the data lines (D₁-Dₘ) to a control terminal of a driving transistor Qd of the corresponding pixel PX.

A data voltage that is applied to the driving transistor Qd is charged to a capacitor Cst, and, even though the switching transistor Qs is turned off, the charged voltage is sustained. The driving transistor Qd, to which the data voltage is applied, is turned on to output an output current I_{LD} having a value depending on the data voltage. The organic light emitting element LD emits light of changeable intensity according to a magnitude of the driving current I_{LD} and thus the corresponding pixel PX displays an image.

After one horizontal period (or "1H") (a period of a horizontal synchronizing signal Hsync and a data enable signal DE), the data driver 500 and the scanning driver 400 repeat the same operation for a next row of pixels PX_{S}. In this way, a data voltage is applied to all pixels PX_{S} by sequentially applying a scanning signal to all the scanning signal lines (G₁-Gₙ) for one frame. A next frame is started after ending one frame, and the same operation is repeated in the next frame.

Referring to FIGS. 5 to 7, a structure for transferring a driving voltage according to an exemplary embodiment of the present invention is described below in detail.

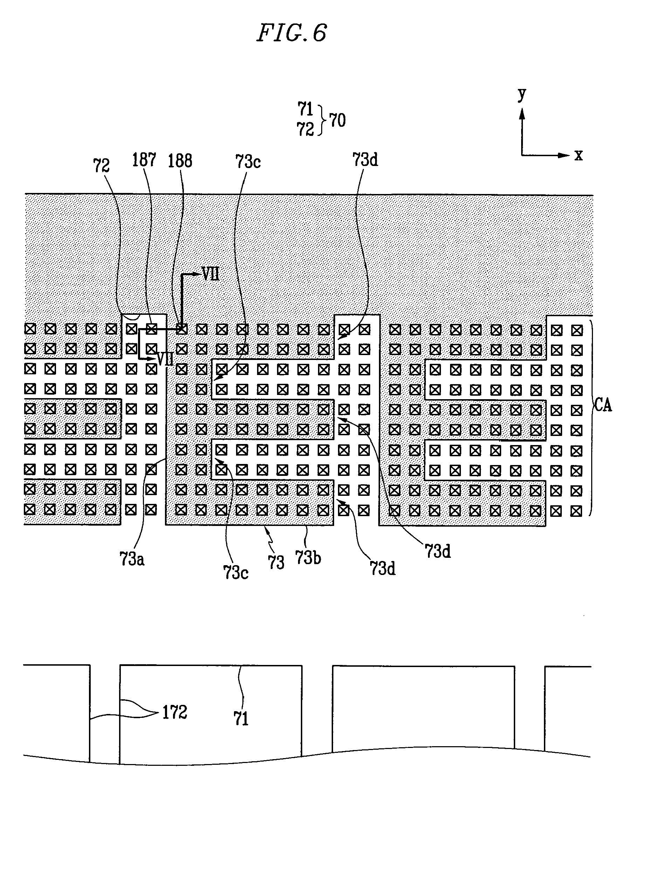

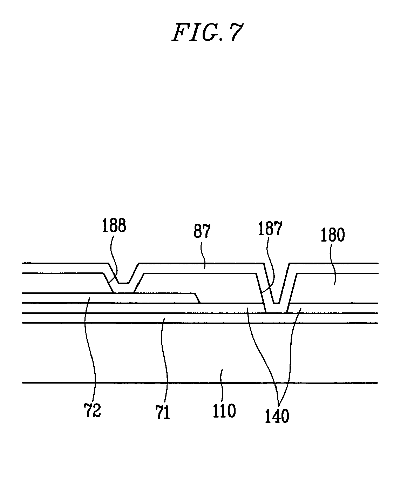

FIG. 5 is a top plan view schematically illustrating an organic light emitting device according to an exemplary embodiment of the present invention, FIG. 6 is an enlarged view of the area displayed with a dotted line in the organic light emitting device of FIG. 5, and FIG. 7 is a cross-sectional view taken along the line VII-VII of FIG. 6.

Referring to FIG. 5, the organic light emitting device includes an insulation substrate 110. The organic light emitting panel 110 includes a display area 111 for substantially displaying an image and a peripheral area 112 including portions 112a-112d surrounding the display area 111.

A plurality of pixels, a plurality of scanning signal lines 121, a plurality of data lines 171, and a plurality of driving voltage lines 172 including each TFT are formed in the display area 111.

The peripheral area 112 is divided into a lower region 112a, an upper region 112b, a left region 112c, and a right region 112d around the display area 111.

A first scanning driver 400a and a second scanning driver 400b, constituting the scanning driver 400, are formed in the left region 112c and the right region 112d, respectively. The first and second scanning drivers 400a and 400b are connected to both ends of each of the plurality of scanning signal lines 121. The scanning driver 400 is integrated on the substrate 110, along with the TFT and the plurality of signal lines 121, 171, and 172. Alternatively, the scanning driver 400 may be implemented using a flexible printed circuit film with a driving circuit chip mounted thereon using a TCP or a chip on film (COF).

A driver 700 and a flexible PCB 650 are attached to the lower region 112a. The driver 700 includes a flexible printed circuit film 710, a driving chip 720 that is mounted on the flexible printed circuit film 710, and a plurality of connection lines 730 that connect the driving chip 720 to the end of the flexible printed circuit film 710 to constitute a pad.

The driving chip 720 includes a voltage generator (not shown), the gray voltage generator 800, the data driver 500, and the signal controller 600.

The voltage generator generates a basic voltage and generates and outputs a voltage necessary for driving the display device, for example, a gate-on voltage Von for turning on a switching element Q of a pixel PX, a gate-off voltage Voff for turning on the switching element Q a reference voltage GVDD, and a driving voltage Vdd and a common voltage Vcom that are applied to the driving voltage line 172, based on the basic voltage.

The driver 700 may be directly mounted on the display panel 300 in the form of at least one driving IC chip (one chip), and the driver 700 may be integrated on the substrate 110, along with the signal lines 121, 171, and 172 and the TFT switching element.

The flexible PCB 650 is attached around one side of the driver 700. The flexible PCB 650 includes a projection 660 that is positioned to the opposite side of the driver 700. The projection 660 is a part for inputting a signal from the outside, and the projection 660 and the driving chip 700 are connected with a signal line.

The driving voltage transferring unit 70 is formed in a part of the upper region 112b, the left region 112c, the right region 112d, and the lower region 112a. In more detail, the driving voltage transferring unit 70 is electrically connected to the connection line 730 of the driver 700 that is attached to the lower region 112a, is formed to enclose the scanning drivers 400a and 400b along the left region 112c and the right region 112d from each of both parts of the lower region 112a, and is formed in the entire upper region 112b. The driving voltage transferring unit 70 is connected to each of a plurality of driving voltage lines 172 in the upper region 112b. The driving voltage transferring unit 70 transfers a driving voltage Vdd that is generated in a voltage generator of the driver 700 to the driving voltage line 172.

Referring to FIGS. 5, 6, and 7, the driving voltage transferring unit 70 includes a first wiring 71 and a second wiring 72 that are disposed in different layers.

The first wiring 71 is formed on the substrate 110, may be disposed in the same layer as the scanning signal line 121 or the data line/driving voltage line 171/172, and may be made of the same material as that of the scanning signal line 121 or the data line/driving voltage line 171/172. The first wiring 71 is directly electrically connected to the driving voltage line 172.

An insulating layer 140 is formed on the first wiring 71.

A second wiring 72 is formed on the insulating layer 140, and the second wiring 72 may be disposed in the same layer as the scanning signal line 121 or the data line/ driving voltage line 171/172 and may be made of the same material as that of the scanning signal line 121 or the data line/driving voltage line 171/172. The first wiring 71 and the second wiring 72 are insulated from each other with the insulating layer 140 disposed therebetween.

A passivation layer 180 is formed on the second wiring 72 and the exposed portion of insulating layer 140. A first contact hole 187 for exposing the first wiring 71 and a second contact hole 188 for exposing the second wiring 72 are formed in the passivation layer 180.

A connecting member 87 is formed on the passivation layer 180. The connecting member 87 is formed in the same layer as the pixel electrode 191 and is made of the same material as that of the pixel electrode 191. The connecting member 87 is electrically connected to the first and second wirings 71 and 72 through the first and second contact holes 187 and 188.

The connecting member 87 and the first and second contact holes 187 and 188 are generally formed in the upper region 112b. A region in which the first and second wirings 71 and 72 are electrically connected is referred to as contact area CA, which is shown in FIG. 6.

In the contact area CA, the boundary line 73 of the first and second wirings 71 and 72 includes one vertical side 73a, a plurality of recess portions 73c, and a plurality of convex portions 73d. The recess portions 73c and the convex portions 73d are formed in one direction about the vertical side 73a, and the convex portions 73c and the recess portions 73d are alternately disposed. Expressed differently, boundary line 73 includes a plurality of portions which extend along the X-axis and a plurality which extend along the Y-axis. As illustrated in FIG.6, the boundary line 73 has a shape similar to that of the letter "E". The phrase boundary line is used only for explanatory purposes to illustrate the geometric configuration of the wirings.

The first and second contact holes 187 and 188 are formed in a plurality of locations around the boundary line 73 of the first and second wirings 71 and 72, and parts of the first and second contact holes 187 and 188 are adjacent to each other with the boundary line 73 disposed therebetween.

If the driving voltage transferring unit 70 is formed in two layers of wirings 71 and 72, a higher voltage can be effectively transferred without widening a width of the wiring.

Each of the first and second wirings 71 and 72 receives a driving voltage Vdd from the driver 700. However, since only the first wiring 71 of the first and second wirings 71 and 72 is connected to the driving voltage line 172, the first and second wirings 71 and 72 should be electrically connected before applying the driving voltage Vdd to the driving voltage line 172. Further, because the first and second wirings 71 and 72 are made of a different material, it is necessary to make equal the current difference due to a voltage drop of the driving voltage Vdd when electrically connecting the first and second wirings 71 and 72 to each other. However, the smooth supply of the driving voltage Vdd may be difficult due to resistance of the connecting member 87 for connecting the first and second wirings 71 and 72.

As in the exemplary embodiment of the present invention, if the boundary line 73 between the first and second wirings 71 and 72 is formed in a bent form, rather than a straight line, a length of the boundary line 73 can be further extended. Accordingly, the number of first and second contact holes 187 and 188 for connecting the first and second wirings 71 and 72 increases, a distance between the two contact holes 187 and 188 becomes narrow, and thus a drop phenomenon of a driving voltage Vdd due to resistance of the connecting member 87 can be minimized.

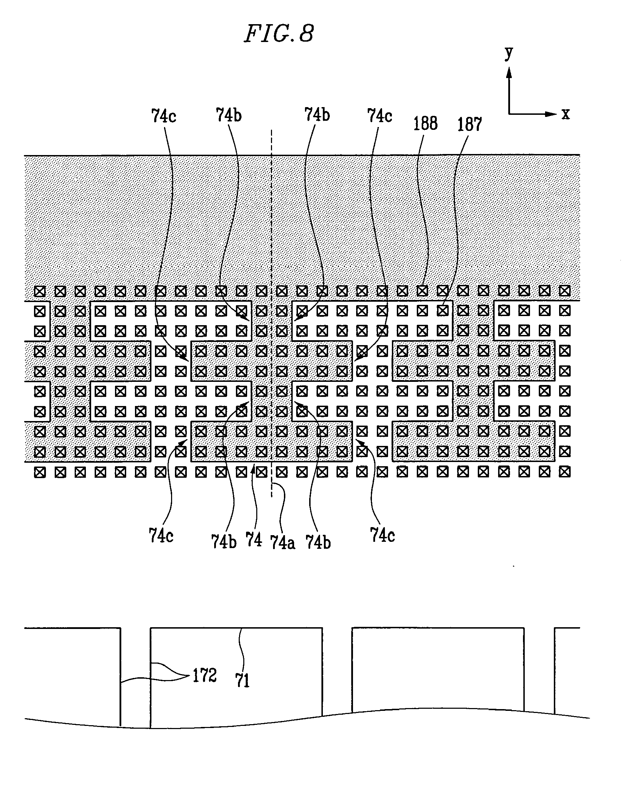

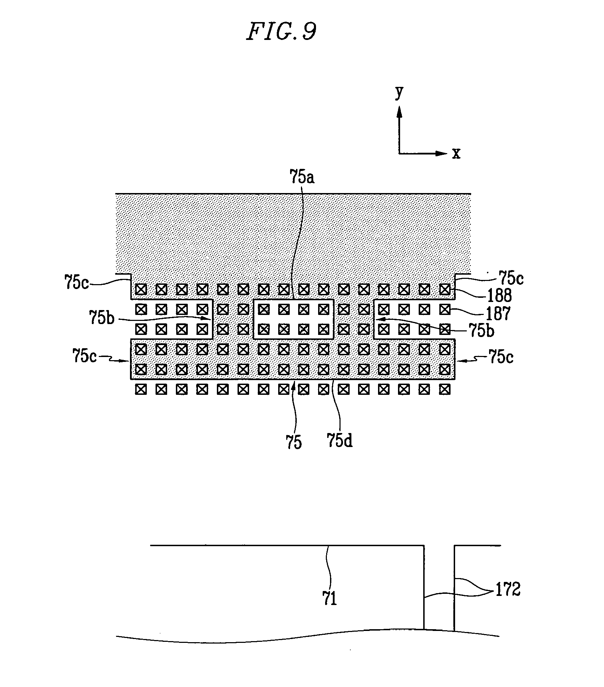

Now, referring to FIGS. 8 and 9, another exemplary embodiment of the present invention will be described in detail.

The driving voltage transferring unit of the display device according to FIGS. 8 and 9 also includes a first wiring 71 and a second wiring 72 that are disposed in different layers, and the first wiring 71 and the second wiring 72 are electrically connected to each other in an upper region 112b. However, boundary lines 74 and 75 of the first and second wirings 71 and 72 in FIGS. 8 and 9 have a form different from the boundary line 73 in FIG. 7, is described below in detail.

First, referring to FIG. 8, the first and second wirings 71 and 72 of the display device according to the present exemplary embodiment are also contacted with a contact area CA, and a boundary line 74 in the contact area CA has a bent shape.

In the contact area CA, the boundary line 74 of the first and second wiring 71 and 72 includes a plurality of recessed portions 74b and a plurality of convex portions 74c. The recessed portions 74b and the convex portions 74c are formed in both directions based on a virtual vertical center line 74a and are alternately disposed. That is, the boundary line 74 has a shape similar to that of a character " 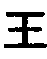 ".

The first and second contact holes 187 and 188 are formed in pluralities around the boundary line 74 of the first and second wirings 71 and 72, and parts of the first and second contact holes 187 and 188 are adjacent to each other with the boundary line 74 disposed thererbetween.

Referring to FIG. 9, the first and second wirings 71 and 72 of the display device according to the present exemplary embodiment are also contacted with a contact area CA, and a boundary line 75 in the contact area CA has a bent shape, that is, having some portions extending in the X-direction and some extending in the Y-direction.

In the contact area CA, the boundary line 75 of the first and second wiring 71 and 72 includes a central closed bent line 75a, a plurality of recess portions 75b, a plurality of convex portion 75c and a horizontal side 75d. The recess portions 75b are formed in both directions about the closed bent line 75a, having a rectangular shape, and the horizontal side 75d is positioned under the closed bent line 75a and the plurality of vertical recess portions 75b. That is, the boundary line 75 has a shape similar to that of a character " 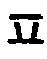 ".

The first and second contact holes 187 and 188 are formed in pluralities around the boundary line 75 of the first and second wirings 71 and 72, and parts of the first and second contact holes 187 and 188 are adjacent to each other with the boundary line 75 disposed thererbetween.

Further, a boundary line of the first and second wirings 71 and 72 can be formed to be bent in various forms to increase the number of first and second contact holes 187 and 188.

According to the present invention, by preventing a voltage drop from being generated at a process of transferring a driving voltage, a driving voltage is more stably transferred to an organic light emitting device, and thus uniformity of a screen can be improved.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A display device comprising:
a substrate comprising a display area and a peripheral area;
a driving voltage line formed in the display area;
a first driver positioned in the peripheral area; and
a driving voltage transferring unit coupled between the first driver and the driving voltage line, the voltage transferring unit being adapted to transfer a driving voltage from the first driver to the driving voltage line ,
wherein the driving voltage transferring unit comprises a first wiring and a second wiring positioned in different layers,
wherein the first wiring and the second wiring are connected to each other via a first group of plurality a of first contact holes for exposing the first wiring and a second group of a plurality of second contact holes for exposing the second wiring, in a contact area, the first and second groups being spaced apart along a boundary line,
wherein the boundary line includes first portions extending along a first axis and second portions extending along a second, different axis.

2. The display device according to claim 1 wherein first and second portions of the boundary line are associated such that the boundary line is E-shaped.

3. The display device according to claim 1 wherein first and second portions of the boundary line are associated such that the boundary line is T-shaped.

4. The display device of claim 1, further comprising an electrically conductive connecting member connecting the first wiring and the second wiring through the plurality of first contact holes and the plurality of second contact holes.

5. The display device of claim 1, wherein the first wiring is disposed a first distance from a surface of the substrate and the second wiring is disposed a second, different distance from the surface of the substrate.

6. The display device of claim 1, wherein the boundary line has a plurality of convex portions and a plurality of recess portions that are extend in one direction about the vertical side.

7. The display device of claim 1, wherein the boundary line has a plurality of pairs of convex portions and a plurality of pairs of recess portions, each pair being in opposite directions around a vertical center line.

8. The display device of claim 1, wherein the boundary line has a closed bent line rectangularly shaped.

9. The display device of claim 8, wherein the boundary line also has a pair of recess portions that are opposite to each other about the closed bent line.

10. The display device of claim 1, further comprising a plurality of scanning signal lines that are formed in the display area and a plurality of data lines intersecting the scanning signal lines.

11. The display device of claim 10, wherein the first wiring is comprised of the same material as that of the scanning signal lines or the data lines.

12. The display device of claim 10, wherein the second wiring is made of the same material as that of the scanning signal lines or the data lines.

13. The display device of claim 4, wherein the connecting member is made of a transparent conductive material.

14. The display device of claim 1, wherein the driving voltage transferring unit is formed along the peripheral area.

15. The display device of claim 1, wherein the contact area and the first driver are positioned on opposing edges of the display area.

16. The display device of claim 10, further comprising a second driver coupled to the scanning signal lines, the second driver.

17. The display device of claim 16, wherein the second driver is integrated with the substrate.

18. The display device of claim 16, wherein the second driver is divided into two portions that are opposite to each other with the display area disposed therebetween.

19. The display device of claim 10, wherein the first driver applies a data voltage to the data lines.

20. The display device of claim 1, further comprising an insulating layer positioned between the first wiring and the second wiring.

21. A display device comprising:
a substrate comprising a display area and a peripheral area;
a driving voltage line formed in the display area;
a first driver positioned in the peripheral area; and
a driving voltage transferring unit coupled between the first driver and the driving voltage line, the voltage transferring unit being adapted to transfer a driving voltage from the first driver to the driving voltage line,
wherein the driving voltage transferring unit comprises a first wiring and a second wiring positioned in different layers,
wherein the first wiring and the second wiring are connected to each other via a first group of a plurality of first contact holes for exposing the first wiring and a second group of a plurality of second contact holes for exposing the second wiring, in a contact area, the first and second groups being spaced apart along a boundary line,
wherein the boundary line of the first wiring and the second wiring is curved in the contact area.

22. A method of manufacturing a display device comprising a plurality of pixels, the method comprising:
forming a first wiring on a substrate;
forming a first insulating layer on the first wiring;
forming a second wiring on the insulating layer;
forming a second insulating layer on the second wiring;
forming a first group of contact holes exposing the second wiring on the second insulating layer;
forming a second group of contact holes exposing the first wiring on the second insulating layer and the first insulating layer,
wherein the first and second groups of contact holes are spaced apart along a boundary line which is intermediate the first and second groups; and
forming a connecting member connecting the first and second wirings through the first and second groups of contact holes,
wherein the boundary line is curved.

23. The method of claim 22, wherein the forming of the second group of contact holes comprises:
etching the second insulating layer; and
etching the first insulating layer.

24. The method of claim 23, wherein the etching of the second insulating layer and the etching of the first insulating layer are simultaneously performed.

25. The method of claim 22, wherein the boundary line has a plurality of convex portions and a plurality of recess portions that are disposed at a vertical side and extend in one direction about the vertical side.

26. The method of claim 22, wherein the boundary line has a plurality of pairs of convex portions and a plurality of pairs of recess portions, each pair being in opposite directions around a center vertical line.

27. The method of claim 22, wherein the boundary line has a closed bent line rectangularly shaped.

28. The method of claim 27, wherein the boundary line also has a pair of recess portions that are opposite to each other about the closed bent line.

29. The method of claim 22, wherein the first and second wirings are formed along an edge of the substrate.
